# EUROPEAN PATENT APPLICATION

(11) **EP 2 709 278 A1**
(43) Date of publication of application: **19.03.2014**
(21) Application number: 12184589.5
(22) Date of filing: 14.09.2012
(51) Int. Cl.: H03M 3/02

(54) **An analogue to digital converter**

(71) Applicant: NXP B.V., 5656 AG Eindhoven (NL)
(72) Inventor: Chen,, Chen, Redhill, Surrey RH1 1NY (GB)
(74) Representative: Crawford, Andrew

(57) **Abstract**

An analogue to digital converter (ADC) (600) comprising an input terminal (602) configured to receive an input analogue signal and an output terminal (604) configured to provide an output digital signal. The ADC includes a summer (624) configured to receive the input analogue signal and provide a summer output signal; a processing block (606) configured to convert the summer output signal into the output digital signal; a first digital to analogue converter (618) configured to receive a digital signal representative of the input analogue signal and provide a first feedback signal (616); and a second digital to analogue converter (619) configured to receive a digital signal representative of the input analogue signal and provide a second feedback signal (617). The summer (624) is configured to subtract the first feedback signal (616) and the second feedback signal (617) from the input analogue signal in order to provide the summer output signal The first digital to analogue converter (618) is clocked by a first clock signal (620) and the second digital to analogue converter (619) is clocked by second clock signal (621). The second clock signal (621) is the inverse of the first clock signal (620).

## Description

The present disclosure relates to the field of analogue to digital converters, and in particular, although not necessarily exclusively, to analogue to digital converters having a negative feedback path including a digital to analogue converter

According to an aspect of the invention there is provided an analogue to digital converter comprising:
an input terminal configured to receive an input analogue signal;
an output terminal configured to provide an output digital signal;
a summer configured to receive the input analogue signal and provide a summer output signal;
a processing block configured to convert the summer output signal into the output digital signal;
a first digital to analogue converter configured to receive a digital signal representative of the input analogue signal and provide a first feedback signal;
a second digital to analogue converter configured to receive a digital signal representative of the input analogue signal and provide a second feedback signal; wherein:
the summer is configured to subtract the first feedback signal and the second feedback signal from the input analogue signal in order to provide the summer output signal; and
the first digital to analogue converter is clocked by a first clock signal and the second digital to analogue converter is clocked by second clock signal, and the second clock signal is the inverse of the first clock signal.

Use of the two digital to analogue converters (DACs) that are clocked by inversely related clock signals can enable the gain of the analogue to digital converter (ADC) to be consistent irrespective of any changes in the duty cycle of the clock signal. The level of feedback provided to the summer can be independent of the duty cycle of the clock signal because at any instant in time only one of the DACs will be active since only one will be receiving a positive clock signal and therefore only one will DAC be providing a non-zero feedback signal. Also, the use of two such DACs can reduce jitter sensitivity.

The performance of such an ADC can also be suitable for use in parallel with other ADCs as the gain of each ADC can be kept constant. Therefore, the parallel ADCs may not suffer from significant mismatch which would otherwise degrade performance. Components of the first digital to analogue converter may be shared with components of the second digital to analogue converter. This can make an efficient use of components and processing resources.

The first digital to analogue converter may be the second digital to analogue converter. A single digital to analogue converter can be used to provide the functionality of both the first digital to analogue converter and the second digital to analogue converter as they are never subjected to a high clock signal at the same time due to the inverse relationship of their clock signals.

The first and second feedback signal may return to zero when the associated clock signal is low. In this way, inter-symbol interference between symbols of signals associated with either the first digital to analogue converter or second digital to analogue converter can be reduced or eliminated by having a period of time between symbols for which digital to analogue conversion is not performed. Also, causing the first and second feedback signals to return to zero can reduce jitter sensitivity of the ADC and improve linearity.

The digital signal representative of the input analogue signal for the first and second digital to analogue converters may be the digital output signal or may be different to the digital output signal.

The ADC may further comprise a combiner configured to combine the first feedback signal with the second feedback signal in order to provide a composite feedback signal to the summer.

The first and second feedback signals may be negative feedback signals.

The analogue to digital converter may be a continuous time analogue to digital converter, and may be a sigma-delta modulator.

The processing block may comprise one or more integrators in series configured to integrate the summer output signal. The processing block may further comprise a quantiser configured to convert the output signal from the integrator or integrators into the digital output signal.

There may be provided an integrated circuit comprising any analogue to digital converter disclosed herein.

There may be provided a circuit comprising two analogue to digital converters in parallel. A first analogue to digital converter may be configured to operate on a rising edge of a clock signal and a second ADC may be configured to operate on a falling edge of the clock signal. The two ADCs in parallel can operate satisfactorily due to their good robustness to mismatch, which is provided by a gain value that is independent of clock duty cycle.

Any circuit, integrated circuit or analogue to digital converter disclosed herein may be suitable for portable communications devices. There may be provided a portable communications device comprising any analogue to digital converter, circuit, or integrated circuit disclosed herein. Such a portable communications device may be a mobile telephone, smartphone, tablet, personal digital assistant, or laptop computer, for example.

According to a further aspect of the invention there is provided a method of operating an analogue to digital converter, the method comprising:
receiving an input analogue signal;
subtracting a first feedback signal and a second feedback signal from the received input analogue signal in order to provide a summer output signal;
converting the summer output signal into an output digital signal;
processing a digital signal representative of the input analogue signal with a first digital to analogue converter in order to provide the first feedback signal;
processing a digital signal representative of the input analogue signal with a second digital to analogue converter in order to provide the second feedback signal; and
clocking the first digital to analogue converter with a first clock signal and clocking the second digital to analogue converter with a second clock signal, wherein the second clock signal is the inverse of the first clock signal.

There may be provided a computer program, which when run on a computer, causes the computer to configure any apparatus, including a circuit, ADC, or device disclosed herein or perform any method disclosed herein. The computer program may be a software implementation, and the computer may be considered as any appropriate hardware, including a digital signal processor, a microcontroller, and an implementation in read only memory (ROM), erasable programmable read only memory (EPROM) or electronically erasable programmable read only memory (EEPROM), as non-limiting examples. The software may be an assembly program.

The computer program may be provided on a computer readable medium, which may be a physical computer readable medium such as a disc or a memory device, or may be embodied as a transient signal. Such a transient signal may be a network download, including an internet download.

A description is now given, by way of example only, with reference to the accompanying drawings, in which:
Figure 1 shows an analogue to digital converter (ADC);
Figure 2 shows three waveforms relating to operation of a digital to analogue converter (DAC);
Figure 3 illustrates an example schematic diagram for implementing the DAC of Figure 1;
Figure 4 shows an alternative representation of the architecture shown in Figure 3;
Figure 5 illustrates a clocking scheme that shows the positions of the switches of Figure 4 for processing an example bitstream signal;
Figure 6 shows an ADC according to an embodiment of the invention;
Figure 7 illustrates an example schematic diagram of the block diagram of Figure 6;
Figure 8 illustrates a simplified representation of Figure 7;
Figure 9 shows an alternative representation of the architecture shown in Figure 7;
Figure 10 illustrates a clocking scheme that shows the positions of the switches of Figure 9 for processing an example bitstream signal;
Figure 11 illustrates a clocking scheme that is similar to that of Figure 10, but includes a clock signal with a variable duty cycle;
Figure 12 illustrates simulation results that show how the ADC of Figure 6 can operate consistently irrespective of a change in the duty cycle of the clock signal;
Figure 13 illustrates a method of operating an ADC, such as the one illustrated in Figure 6.

One or more embodiments disclosed herein relate to an analogue to digital converter (ADC) with two digital to analogue converters (DACs) in parallel in a negative feedback loop. The two DACs can be clocked by clock signals that are the inverse of one another. In this way, the gain of the ADC can be independent of the duty cycle of the clock signal as any increase in the on-period of one clock signal is automatically reflected by a decrease in the on-time of the other clock signal. Such an ADC also provides return-to-zero (return-to-zero) processing for each of the DACs, thereby potentially reducing or eliminating inter-symbol interference.

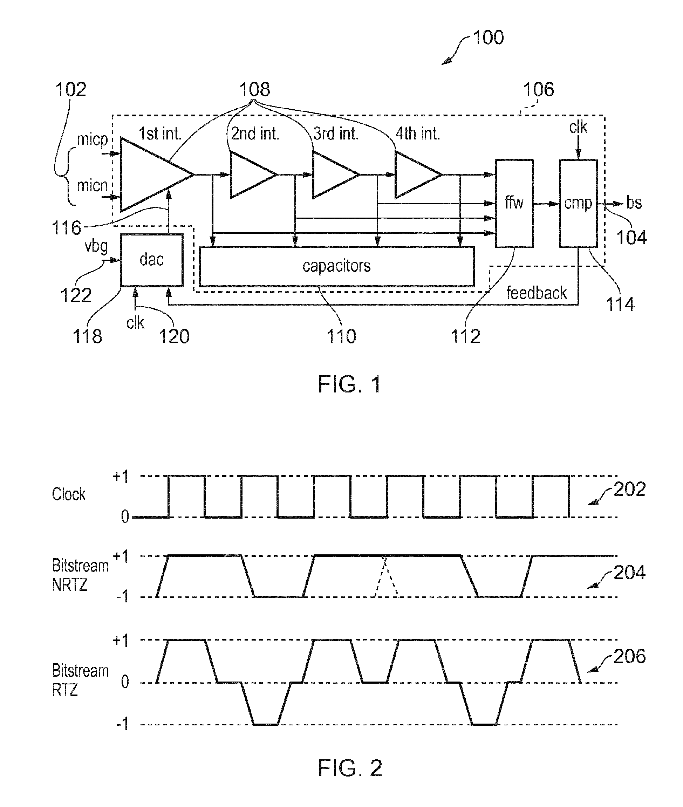

Figure 1 shows an analogue to digital converter (ADC) 100 having an input terminal 102 for receiving analogue one or more input signals and an output terminal 104 for providing one or more output digital signals. In this example, the input signals are a positive and a negative microphone input signal micp and micn and the output digital signal is a bitstream.

The analogue signals received at the input terminal 102 are passed to a processing block 106 for converting into a digital signal. The processing block 106 includes four integrators 108 in series in order to provide a fourth order structure for integrating the received analogue signals. As is known in the art, each of the integrators 108 includes a capacitor, which is shown in Figure 1 as a block of capacitors with reference 110.

The outputs of each of the integrators 108 is provided to a feedforward path component 112 that sums the signals and provides the summed signal to a comparator 114. The comparator 114 quantises the summed signal to provide the digital output bitstream signal bs.

The output of the comparator 114 is also provided as an input to a digital to analogue converter (DAC) 118. The DAC 118 is used to provide a feedback signal 116. The input signal to the DAC 118 may be the same as the digital output signal (bs) or may be a different digital signal representative of the input analogue signal.

The feedback signal 116 in this example is provided to the first integrator 108 of processing block 106, within which it is subtracted from the input signals (micp micn) before the resultant signal is integrated. In this way, the DAC is provided in a negative feedback loop of the ADC 100.

As can be seen in Figure 1, a vbg signal 122 is also provided to the DAC 118. This represents a voltage band gap signal, which is known in the art to provide an analogue reference to the DAC 118.

The DAC is clocked by a clock signal 120 in order to provide return-to-zero functionality, as described in more detail below with reference to Figure 2.

Figure 2 shows three waveforms that illustrate the advantages in clocking a DAC such that a received digital signal is not continuously converted to an analogue signal.

The first waveform in Figure 2 is a clock signal 202.

A bitstream that has not been subjected to a return-to-zero (RTZ) between successive bits is shown in the second waveform 204 in Figure 2. Two consecutive high bits are shown towards the middle of the bitstream 204. It can be seen that the area between the waveform 204 and the zero axis for these two bits is not equal to twice the area for a single bit. This is due to the unavoidable time delays in any circuit that prevent an instantaneous transition between different logical levels. This is visible in Figure 2 by the oblique transitions in the bitstream 204. This variation in the representation of bits can lead to inter-symbol interference when the bitstream is converted to an analogue signal thereby degrading the performance of the DAC.

The same bitstream that does have return-to-zero between bits is shown in the third waveform 206 in Figure 2. The RTZ bitstream 206 is the product of the clock signal 202 and the non-RTZ bitstream 204. The return-to-zero regions can be seen by the portions of the waveform at level 0. By using such a return-to-zero it can be seen that the area between the waveform 204 and the zero axis for each bit in the bitstream is consistent irrespective the value of a neighbouring bit. This can enable a consistent conversion of each digital bit into an analogue signal and can reduce the inter-symbol interference that may occur with conversion of the non-RTZ bitstream 204.

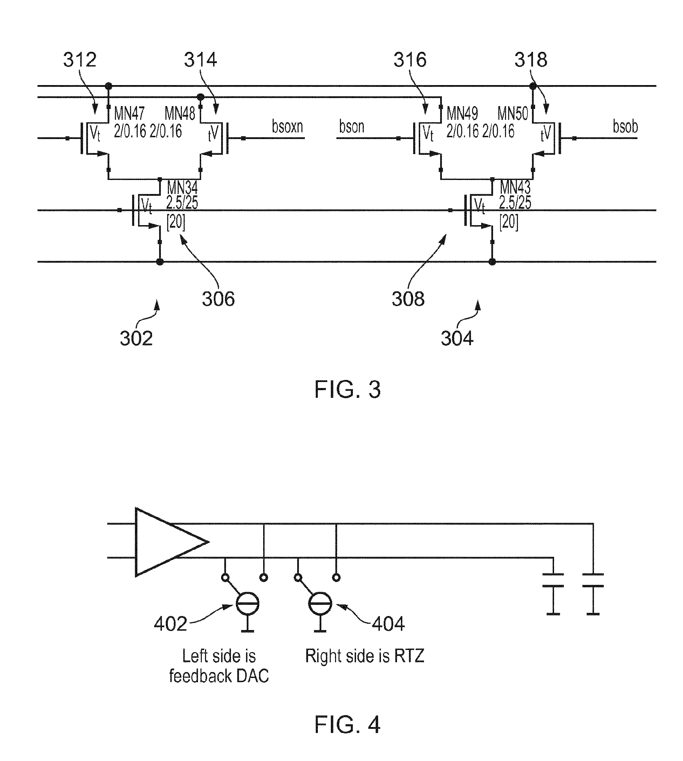

Figure 3 illustrates an example schematic diagram for implementing the DAC of Figure 1 with return-to-zero functionality. The right-hand side of the architecture, shown with reference number 304, is used to process the feedback to be provided by the DAC. The left-hand side of the architecture, shown with reference number 302, is used to reset the DAC at times when the signal has returned-to-zero.

Figure 4 is an alternative representation of the architecture shown in Figure 3. The right hand side of the architecture in Figure 3 has been replaced with a first switch 402 in Figure 4. The left hand side of the architecture in Figure 3 has been replaced with a second switch 404. Each switch shown in Figure 4 is implemented by two transistors.

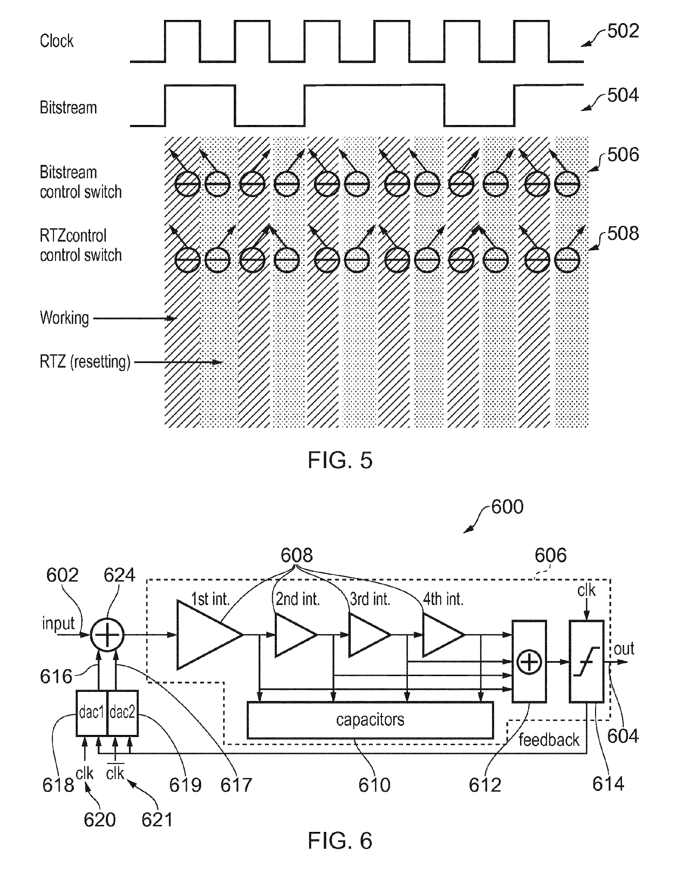

Figure 5 illustrates a clocking scheme that shows the positions of the first and second switches of Figure 4 for processing an example bitstream signal 504. The clock signal is shown with reference 502. The position of the first switch is identified as the bitstream control switch 506 in Figure 5. The position of the second switch is identified as the RTZcontrol control switch 508 in Figure 5.

It can be seen that the RTZcontrol control switch 508 corresponds to: the value of the bitstream 504 when the clock signal 502 is high; and the inverse value of the bitstream 504 when the clock signal 502 is low. The bitstream control switch 506 corresponds to the bitstream signal 504. The regions illustrated with a dot-filled area, when the RTZcontrol control switch 508 is is different to the bitstream control signal 506, represent the return-to-zero or reset regions when the output of the DAC is zero.

Figure 6 shows an ADC 600 according to an embodiment of the invention. In this embodiment the ADC is a sigma-delta modulator. Features that are common to both Figures 1 and 6 will not necessarily be described again here.

In this example, the feedforward path component of Figure 1 is represented as a summer 612 and the comparator is represented as a quantiser 614. Also, a summer 624 is provided externally to the first integrator 608.

This example has two DACs 618, 619 in parallel with each other in the negative feedback path. A first DAC 618 is clocked by a first clock signal 620 and provides a first feedback signal 616. A second DAC 619 is clocked by a second clock signal 621 and provides a second signal 617. The summer 624 subtracts the first and second feedback signals 616, 617 from the input signal received at the input terminal 602, in order to provide a summer output signal to the first integrator 608 in the processing block 606. The feedback signals 616, 617 from the two DACs 618, 619 can be considered together as a composite feedback signal, which can be provided as a common input to a subtracting input of the summer 624.

In some examples, a combiner/summer may be provided to combine the first and second feedback signal 616, 617 in order to provide a single composite feedback signal to a subtracting input of the summer 624.

The second clock signal 621 for the second DAC 619 is the inverse of the first clock signal 620 for the first DAC 618. In this way only one of the two clock signals 620, 621 is high at any instant time, which means that only one of the DACs 618, 619 provides a non-zero feedback signal 616, 617 to the summer 624 at any one time. The alternate use of the DACs 618, 619 during the clock cycle to provide a feedback signal means that each of the DACs 618, 619 benefits from return-to-zero functionality and reduced inter-symbol interference, as described above.

Use of the two DACs 618, 619 in parallel also provides a more robust ADC 600 in terms of its sensitivity to variations in the duty cycle of the clock signal. In some situations, the clock duty cycle can vary between 40% and 60%. The ADC 600 can maintain a substantially constant gain irrespective of the duty cycle of the clock, thereby reducing jitter sensitivity. This is because any changes in the duty cycle of the clock signal will not cause a difference in the value or level of the composite feedback signal that is provided to the summer 624. If the duration of one of the DAC feedback signals 616, 617 increases due to a change in duty cycle then the duration of the other DAC feedback signal 616, 617 is automatically decreased by the same amount. In this way, the composite feedback signal that is received by the summer 624 is not dependent on any specific duty cycle.

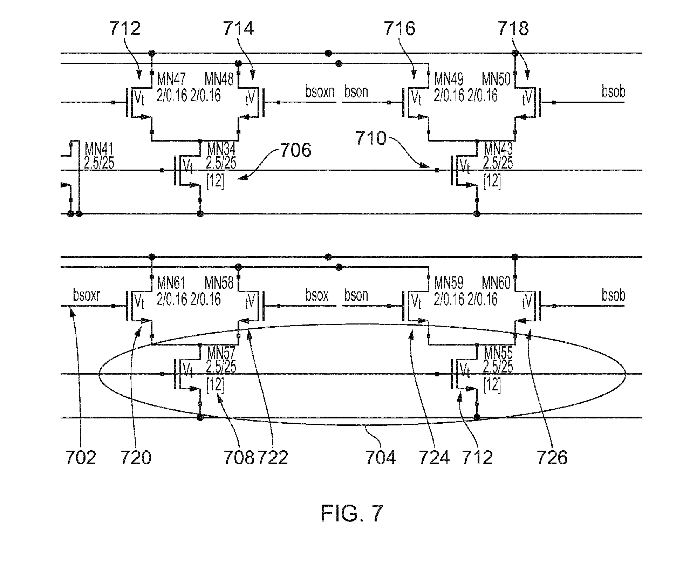

Figure 7 illustrates an example schematic diagram of the block diagram of Figure 6. Current sources are shown in a circle 704 towards the bottom of Figure 7. A comparison with the schematic of Figure 3 reveals that the transistor with label MN34 306 in Figure 3 has multiple of 20, has been split into two transistors for the schematic of Figure 7: transistor with label MN34 706 with a multiple of 10 and transistor with label MN 57 708 also with a multiple of 10 in Figure 7. A similar split has been made for transistor MN43 308 in Figure 3 into transistors MN43 710 and MN55 712 in Figure 7. The change in multiple for these transistors from 20 in Figure 3 to 10 in Figure 7 accounts for the fact that the combined DACs in Figure 7 provide a feedback signal for twice as long as the circuit of Figure 3, thereby enabling the same amount of charge to be provided to the capacitors of the integrators for a single complete clock cycle (both high and low time).

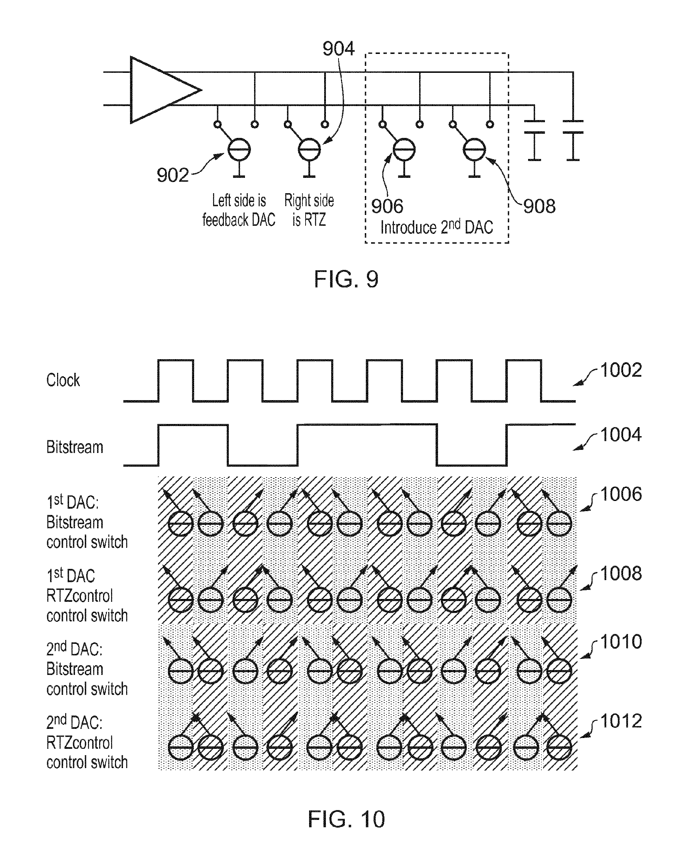

Figure 7 has all of the features that are shown in Figure 3, with four additional transistors 702. These four additional transistors 702 represent two additional switches as shown in Figure 9.

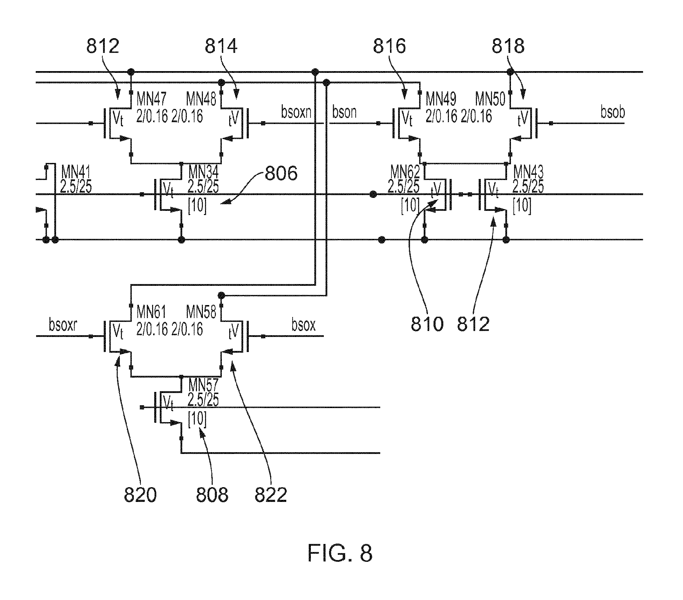

Figure 8 illustrates a simplified representation of Figure 7. The top-right switch of Figure 7, which is implemented by transistors MN49 716 and MN50 718, is identical to the bottom right switch implemented by transistors MN59 724 and MN60 726. This is described in more detail below with reference to the clocking scheme of Figure 10. In Figure 8 these two identical switches have been combined and the associated current sources of Figure 7 (transistors MN43 710 and MN55 712) have been brought together and provided in parallel as transistors MN43 812 and MN62 810 in Figure 8. In this way, the number of transistors has been reduced by two in Figure 8 from the schematic of Figure 7. In fact, the right side Figure 8 is functionally the same as the right side of Figure 3 (although the current source transistor has been split into two). Compared with Figure 3, the current source transistor MN34 306 has been split into two transistors (MN34 806 and MN57 808 in Figure 8) and two transistors (MN 58 822 and MN61 820) have been added to provide an extra switch. This can be very easy and cost effective to implement.

Figure 9 is an alternative representation of the architecture shown in Figure 7. Four switches 902, 904, 906, 908 are shown in total. This represents two additional switches 906, 908 when compared with Figure 4. The four switches are:
- a first switch 902 that represents bitstream control for the first DAC;
- a second switch 904 that represents the return-to-zero enablement of the first DAC;
- a third switch 906 that represents bitstream control for the second DAC; and
- a fourth switch 908 that represents the return-to-zero enablement of the second DAC.

Figure 10 illustrates a clocking scheme that shows the positions of the first, second, third and fourth switches of Figure 9 for processing an example bitstream signal 1004. The clock signal is shown with reference 1002 and has a consistent duty cycle in this example.

The position of the first switch is identified as the first DAC bitstream control switch 1006 in Figure 10. The position of the second switch is identified as the first DAC RTZcontrol control switch 1008. The position of the third switch is identified as the second DAC bitstream control switch 1010. The position of the fourth switch is identified as the second DAC RTZcontrol control switch 1012.

It can be seen that the first DAC RTZcontrol control switch 1008 corresponds to: the value of the bitstream 1004 when the clock signal 1002 is high; and the inverse value of the bitstream 1004 when the clock signal 1002 is low. Similarly, the second DAC RTZcontrol control switch 1012 corresponds to: the value of the bitstream 1004 when the clock signal 1002 is low; and the inverse value of the bitstream 1004 when the clock signal 1002 is high. The bitstream control switches 1006, 1010 for both the first and second DACs corresponds to the bitstream signal 1004.

The areas illustrated with a dot-filled area, when a RTZcontrol control switch 1008, 1012 is different to the associated bitstream control signal 1006, 1010, represents the return-to-zero regions of the associated DAC. It can be seen that one and only one of the DACs is always at RTZ, and therefore one and only one DAC is providing a non-zero output signal.

As can be seen in Figure 10 and as discussed above, the first bitstream control switch signal 1006 (corresponding to the first switch 902 in Figure 9) and the second bitstream control switch signal 1010 (corresponding to the third switch 906 in Figure 9) are the same. Therefore the associated switches can be combined and implemented as a single switch by two transistors.

It will be appreciated from Figures 7, 8 and 9 that the only new additional component that is required to convert the ADC of Figure 1 into the ADC of Figure 6 is one extra switch (two extra transistors).

By splitting/using a single DAC as two DACs that are clocked with inversely-related clock signals little or no extra current is required by the circuit. Therefore, little or no extra power is consumed. This is because the only additional component that is required is a switch, which does not consume power. Further still, since only two extra transistors are required, only a very small amount of extra silicon area in an integrated circuit (IC) is required.

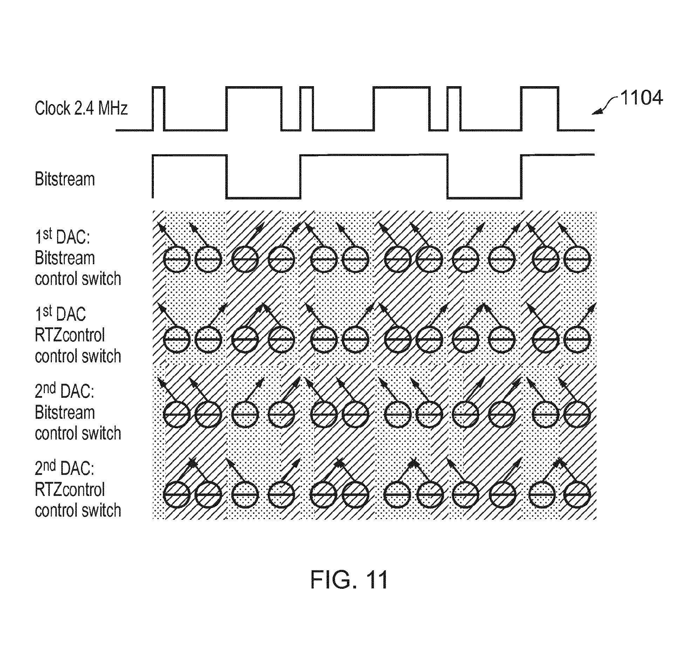

Figure 11 illustrates a clocking scheme that is similar to that of Figure 10, but includes a clock signal 1104 with a variable duty cycle. In the same way as for Figure 10, one and only one of the DACs is always providing a non-zero output signal irrespective of the duty cycle of the clock signal 1104.

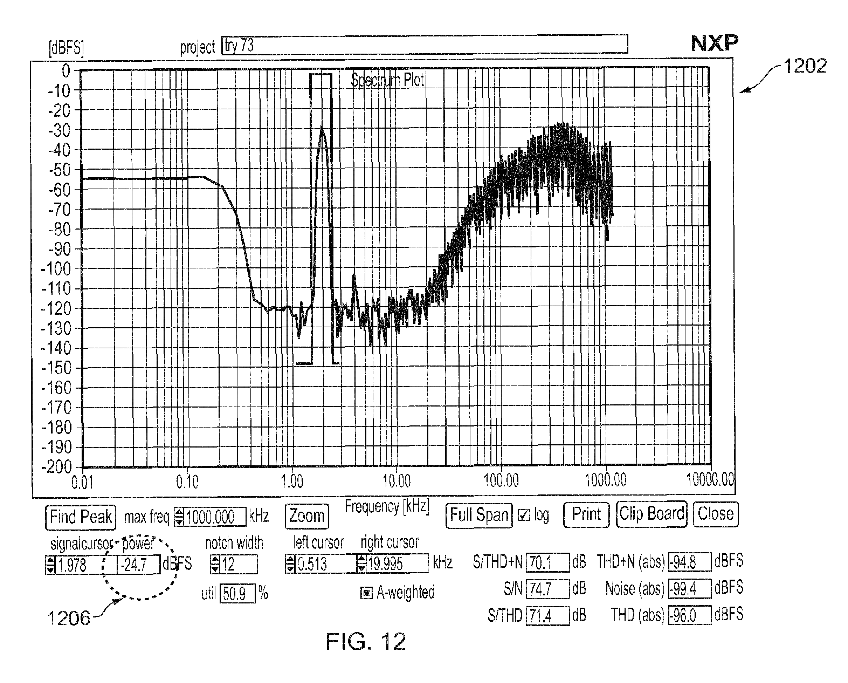

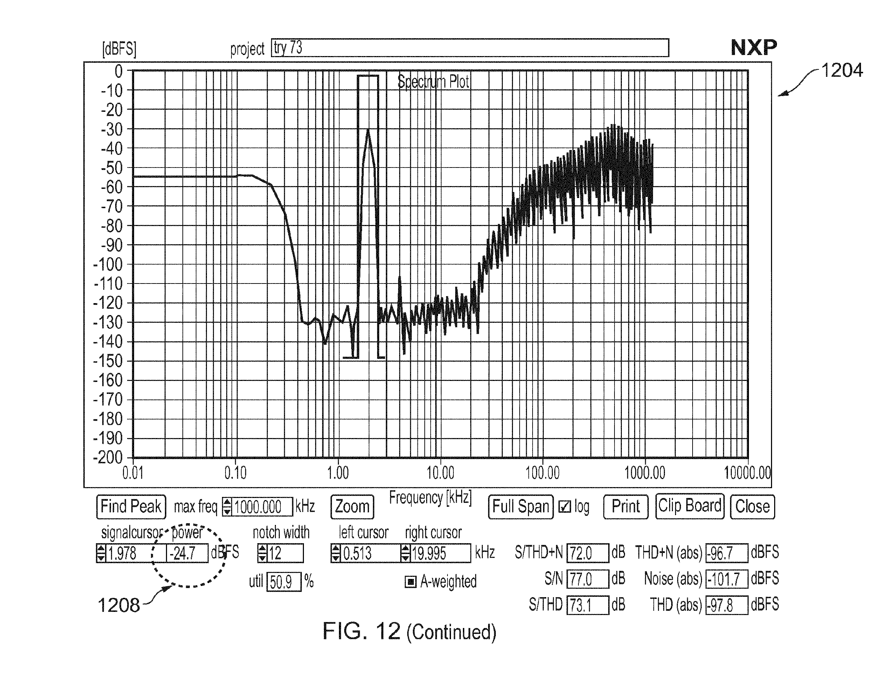

Figure 12 illustrates simulation results that show how the ADC of Figure 6 can operate with a consistent gain irrespective of a change in the duty cycle of the clock signal. Two plots are shown in Figure 12: a left plot 1202 and a right plot 1204. Both plots 1202, 1204 show frequency on the horizontal axis and power in dBFS (decibels full scale) on the vertical axis.

The left plot 1202 represents performance of the ADC of Figure 6 subjected to a clock signal with a 40% duty cycle. The right plot 1204 represents performance of the ADC of Figure 6 subjected to a clock signal with a 60% duty cycle.

It can be seen that the left plot 1202 is identical to the right plot 1204. This is further evidenced by the data shown in circles 1206, 1208 on both of the plots, which show an identical power level of -24.7 dBFS at 1.978 kHz.

It will be appreciated that one or more of the implementation features described herein in relation to one example can be used with other examples. For example, features shown in Figure 1 can be substituted into Figure 6, and vice versa.

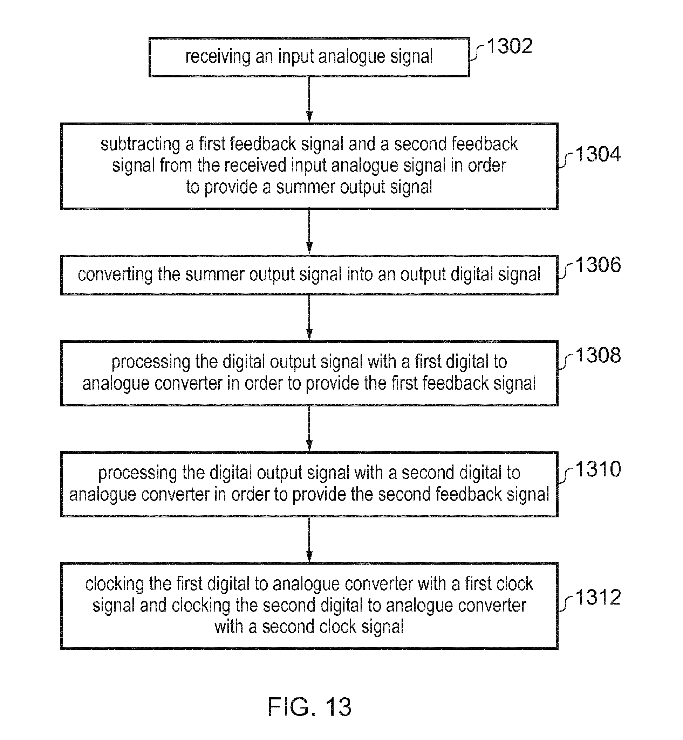

Figure 13 illustrates a method of operating an ADC, such as the one illustrated in Figure 6.

The method begins at step 1302 with receiving an input analogue signal. At step 1304 the method continues with subtracting a first feedback signal and a second feedback signal from the received input analogue signal in order to provide a summer output signal. The first and second feedback signals provide negative feedback.

At step 1306 the method comprises converting the summer output signal into an output digital signal. At step 1308, the method consists of processing the digital output signal with a first digital to analogue converter in order to provide the first feedback signal. At step 1310, the method consists of processing the digital output signal with a second digital to analogue converter in order to provide the second feedback signal. Steps 1308 and 1310 can be performed in parallel by two DACs that in parallel in a negative feedback loop.

The method continues at step 1312 by clocking the first digital to analogue converter with a first clock signal and clocking the second digital to analogue converter with a second clock signal. The second clock signal is the inverse of the first clock signal. In this way, the ADC may be operated such that it is robust to changes in the duty cycle of the clock signal, as well as providing good inter-symbol interference.

Embodiments disclosed herein relate to a robust ADC design with clock duty cycle variant immunity. The ADC can use a continuous time 4th order sigma-delta structure. RTZ (Return-To-Zero) can be used to prevent or reduce ISI (inter-Symbol-Interference), reduce jitter sensitivity and improve linearity. Anti-phase "Dual DACs" can provide for an ADC having constant gain with variable clock duty cycles and reduced jitter sensitivity. An ADC disclosed herein can operate satisfactorily for any duty cycle between 1% and 99%, and also for variable duty cycle.

One or more ADCs disclosed herein with two DACs in the feedback path are based on integration structure that uses the complete clock cycle (2 x t) for integration. In order for the same amount of charge to be integrated into capacitors, the current needs to be half (0.5 x I) that of the circuit of Figure 3 as the two DACs cumulatively provide a feedback signal for twice as long.

## Claims

1. An analogue to digital converter (600) comprising:
an input terminal (602) configured to receive an input analogue signal;
an output terminal (604) configured to provide an output digital signal;
a summer (624) configured to receive the input analogue signal and provide a summer output signal;
a processing block (606) configured to convert the summer output signal into the output digital signal;
a first digital to analogue converter (618) configured to receive a digital signal representative of the input analogue signal and provide a first feedback signal (616); and
a second digital to analogue converter (619) configured to receive a digital signal representative of the input analogue signal and provide a second feedback signal (617); wherein:
the summer (624) is configured to subtract the first feedback signal (616) and the second feedback signal (617) from the input analogue signal in order to provide the summer output signal; and
the first digital to analogue converter (618) is clocked by a first clock signal (620) and the second digital to analogue converter (619) is clocked by second clock signal (621), and the second clock signal (621) is the inverse of the first clock signal (620).

2. The analogue to digital converter of claim 1, wherein the first and second feedback signals return to zero when the associated clock signal is low.

3. The analogue to digital converter of claim 1 or claim 2, further comprising a combiner configured to combine the first feedback signal with the second feedback signal in order to provide a composite feedback signal to the summer.

4. The analogue to digital converter of any preceding claim, wherein the first and second feedback signals are negative feedback signals.

5. The analogue to digital converter of any preceding claim, wherein the analogue to digital converter is a continuous time analogue to digital converter.

6. The analogue to digital converter of any preceding claim, wherein the analogue to digital converter is a sigma-delta modulator.

7. The analogue to digital converter of any preceding claim, wherein components of the first digital to analogue converter are shared with components of the second digital to analogue converter.

8. The analogue to digital converter of claim 7, wherein the first digital to analogue converter is the second digital to analogue converter.

9. The analogue to digital converter of any preceding claim, wherein the digital signal representative of the input analogue signal for the first and second digital to analogue converters is the digital output signal.

10. The analogue to digital converter of any one of claims 1 to 8, wherein the digital signal representative of the input analogue signal for the first and second digital to analogue converters is different to the digital output signal.

11. The analogue to digital converter of any preceding claim, wherein the processing block comprises one or more integrators (608) in series configured to integrate the summer output signal.

12. The analogue to digital converter of claim 11, wherein the processing block further comprises a quantiser (614) configured to convert the output signal from the integrator or integrators into the digital output signal.

13. An integrated circuit comprising the analogue to digital converter of any preceding claim.

14. A method of operating an analogue to digital converter, the method comprising:
receiving an input analogue signal;
subtracting a first feedback signal (616) and a second feedback signal (617) from the received input analogue signal in order to provide a summer output signal;
converting the summer output signal into an output digital signal;
processing a digital signal representative of the input analogue signal with a first digital to analogue converter (618) in order to provide the first feedback signal (616);
processing a digital signal representative of the input analogue signal with a second digital to analogue converter (619) in order to provide the second feedback signal (617); and
clocking the first digital to analogue converter (618) with a first clock signal (620) and clocking the second digital to analogue converter (619) with a second clock signal (621), wherein the second clock signal (621) is the inverse of the first clock signal (620).

15. A computer program, which when run on a computer, causes the computer to configure the analogue to digital converter of any one of claims 1 to 12, the integrated circuit of claim 13, or perform the method of claim 14.
